# EUROPEAN PATENT SPECIFICATION

(11) **EP 1 211 558 B1**
(45) Date of publication and mention of the grant of the patent: **01.07.2015**
(21) Application number: 01934361.5
(22) Date of filing: 28.05.2001
(51) Int. Cl.: G03F 1/84

(54) **SUBSTRATE SELECTOR**
AUSWAHLVORRICHTUNG FÜR SUBSTRATE
SELECTEUR DE SUBSTRAT

(30) Priority: 02.06.2000 JP 2000166248; 31.07.2000 JP 2000232215
(43) Date of publication of application: 05.06.2002
(73) Proprietor: DAI NIPPON PRINTING CO., LTD., Tokyo 162-8001 (JP)
(72) Inventor: ISHIDA, Kouji Dai Nippon Priting Co., Ltd., Shinjuku-ku, Tokyo 162-8001 (JP); YAMAZAKI, Kiyoshi Dai Nippon Priting Co., Ltd., Shinjuku-ku, Tokyo 162-8001 (JP); NARA, Hideyuki Dai Nippon Priting Co., Ltd., Shinjuku-ku, Tokyo 162-8001 (JP); SEINO, Hajime Dai Nippon Priting Co., Ltd., Shinjuku-ku, Tokyo 162-8001 (JP)
(74) Representative: Goddar, Heinz J.
(86) International application number: PCT/JP2001/004427
(87) International publication number: WO 2001/095029

(56) References cited:
- JP-A- 9 051 028
- US-A- 5 737 072
- US-A- 5 777 901
- US-A- 5 801 965
- US-A- 5 991 699

## Description

### TECHNICAL FIELD

The present invention relates to substrate-selecting equipment for a photomask used for the production of a semiconductor integrated circuit and in particular to substrate-selecting equipment for selecting a substrate used for an objective product from among a group of substrates used for the production of photomasks.

### BACKGROUND ART

As state of the art US 5,801,965 "Techniques for improving inspection of manufactured items" is mentioned, which however only describes a computer program calculating the number of defects and defining minimum and maximum thresholds of defect numbers.

In recent years, a high degree of integration and high functionality are increasingly desired for various LSI typified by ASIC, from the tendency of electric equipment becoming highly efficient and lighter, thinner, shorter and smaller. In a photomask used for the production of a semiconductor integrated circuit, the formation of patterns of a photomask with high efficiency and high quality has become desirable.

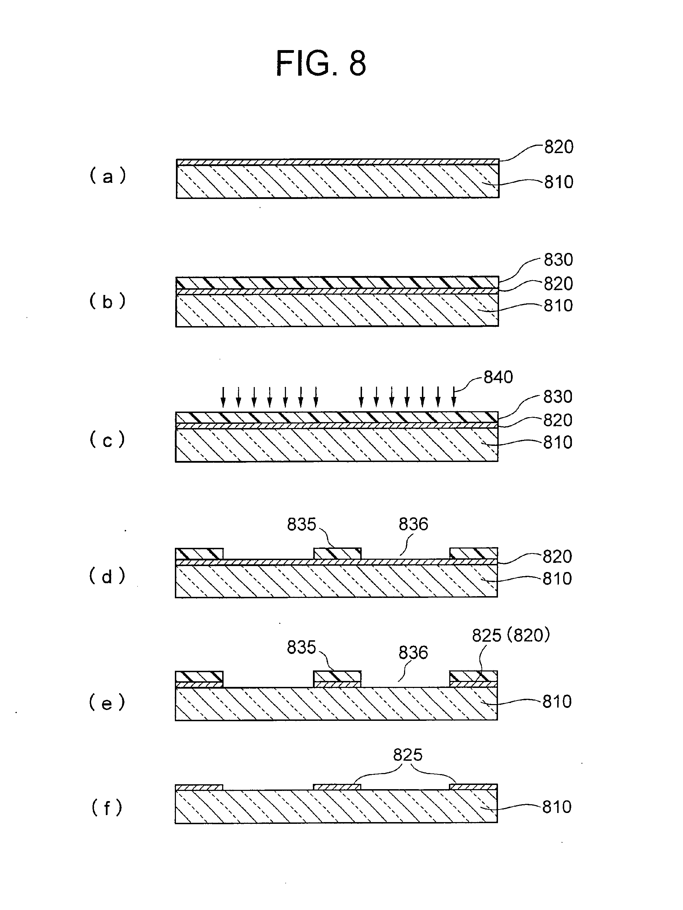

Heretofore, the production of a photomask is carried out generally through the steps shown in Fig. 8.

First, as shown in Fig 8(a), a substrate (it is called a "blank") provided with a shielding film or a shifter layer 820 made of a metallic thin film such as chromium formed on a transparent substrate 810 by sputtering and others, is provided.

Then, as shown in Fig. 8(b), a photosensitive material layer (it is called "photosensitive resin film", a "photosensitive resist" or merely a "resist") 830 is laminated on to the shielding film or the shifter layer 820, and then dried by heating to remove solvent remaining in the photosensitive material layer and to improve the adhesion between the metallic thin film and the transparent substrate.

Then, as shown in Fig. 8(c), ionizing radiation 840 such as EB (electron beams), laser beams, or X-rays, is applied so as to selectively form the ionizing radiation into a desired pattern. Generally, the ionizing radiation 840 is selectively formed by means of the fixed equipment according to pattern data for the formation of the pattern. Therefore, it is also called "pattern writing" or merely "writing".

Then, as shown in Fig. 8(d), the photosensitive material layer 830 is developed to form a resist pattern 835. Thereafter, as shown in Fig. 8(e), areas of the shielding layer 820 made of metallic thin film except the openings 836 of the resist pattern 835 are etched so that a shielding layer pattern 825 is formed.

Finally, the resist pattern 835 is removed so that a photomask with the shielding layer pattern 825 can be obtained as shown in Fig. 8(f). Thereafter, an inspection is carried out and a correction of the pattern is carried out as necessary so that a desired photomask is obtained.

It goes without saying that the quality of the photomask produced in the above-mentioned process is greatly affected by the quality of the substrate with the photosensitive material layer employed for pattern writing. However, there are many kinds of substrates with photosensitive material layer. Therefore, the control of substrates with a photosensitive material layer is difficult. Until now the distinction between good products and poor products is carried out according to the regular standard in the inspection in the process of production so that only good products are employed.

However, there are various quality specifications for objective products, and substrates with photosensitive material layers distinguished as good products vary in the degree of quality and the sensitivity of the photosensitive material layers. Therefore, it can not be said that substrates corresponding to the specifications of objective products were selected. Accordingly, there are cases where the influence of the substrate used on the inspection and correction process thereof was considerable.

Further, as circuits of semiconductor products such as LSI chips are becoming denser and ever smaller, the formation of patterns of higher accuracy and higher quality has become desirable.

It is an object of the present invention to provide a substrate-selecting equipment wherein substrates used for the production of objective products can be successfully selected from among a group of substrates with photosensitive material layers used for the production of photomasks employed for writing patterns in the process of manufacturing a photomask, particularly from the aspect of the quality of products.

### DISCLOSURE OF THE INVENTION

The present invention is substrate-selecting equipment for selecting substrates with the features of claim 1. Preferred embodiments are subject matter of claims 2 to 4.

Further, patterns on a photomask are formed by the steps shown in Fig. 8, wherein ionizing radiation 840 such as EB (electron beams), laser beams, X-rays, is applied to a photosensitive material layer 830 of a substrate with a photosensitive material layer so as to selectively expose the photosensitive material layer to the ionizing radiation to form a desired pattern by which a latent image thereof is formed. Generally, ionizing radiation 840 selectively exposes by means of the fixed equipment according to pattern data for the formation of a pattern. Therefore, it is also called "pattern writing" or merely "writing" and a pattern area on a photomask is also called a "writing area".

The substrate-selecting equipment of the present invention having the above-mentioned setup enables the provision of the substrate-selecting equipment in which substrates used for the provision of objective products can be successfully selected from among a group of substrates with photosensitive material layers employed for writing of a pattern in a photomask provided, particularly from the aspect of product quality.

Specifically this is achieved by the substrate-selecting equipment for selecting substrates used for objective parts from among a group of substrates with photosensitive material layers used for the production of a photomask, wherein the substrate-selecting equipment comprises one or more defect registering parts for registering the results of the inspection for defects of substrates with photosensitive material layers in a database, the photosensitive material layer lot check result registering part and the substrate-selecting part for selecting substrates used for the production of objective products from among a group of a group of substrates with a photosensitive material layer on the basis of the results of the inspection for defects and the results of check of lots of photosensitive material layers registered in database.

The above-mentioned substrate-selecting equipment further comprises the selection standard registering part for registering the quality standard (it is also called the "rank") of substrates which is the standard of selection of substrates in a database, wherein the substrate selection part can select substrates used for the production of objective products on the basis of the information in the results of checking lots of photosensitive material layers and the quality standard of substrates which is the standard of the selection of substrates, as necessary.

Further, the above-mentioned substrate-selecting equipment comprises the defect probability calculating part wherein the probability that no defect exists or the probability that it exists in the surrounding part of a pattern on a photomask produced is extracted corresponding to the patterns of the photomask to be produced on every substrate, on the basis of the information in the results of the inspection for defects of each substrate and the information in the results of checking lots of photosensitive material layers registered in a database for a candidate substrate nominated as candidate for a substrate used for the photomask to be produced, and wherein the substrate-selecting part can select substrates used for the production of objective products on the basis of the probability that no defect exists or the probability that defects exist in the surrounding part of the pattern on every substrate obtained in the defect probability calculating part, or from the probability that no defect exists or the probability that defects exist in the whole of the pattern, as necessary.

### BRIEF DESCRIPTION OF DRAWING

Fig. 1 is a schematic view showing an example of a mode of operation of substrate-selecting equipment of the present invention.
Fig. 2 is a view showing an example of data on the results of inspection for defects.
Fig. 3 is a view showing an example of data on the results of checking lots of photosensitive layers.
Fig. 4 is a view showing an example of a quality standard.
Fig. 5 is a view showing an example of a process of inputting the selection of the substrate.
Fig. 6 is a flow diagram showing an example of procedures of choosing a substrate referring to a view of selection of substrate.
Fig. 7 is a view for explaining an example of the action of a defect probability calculating part.
Fig. 8 is a view for explaining a process of producing a photomask.

### BEST MODE FOR CARRYING OUT THE INVENTION

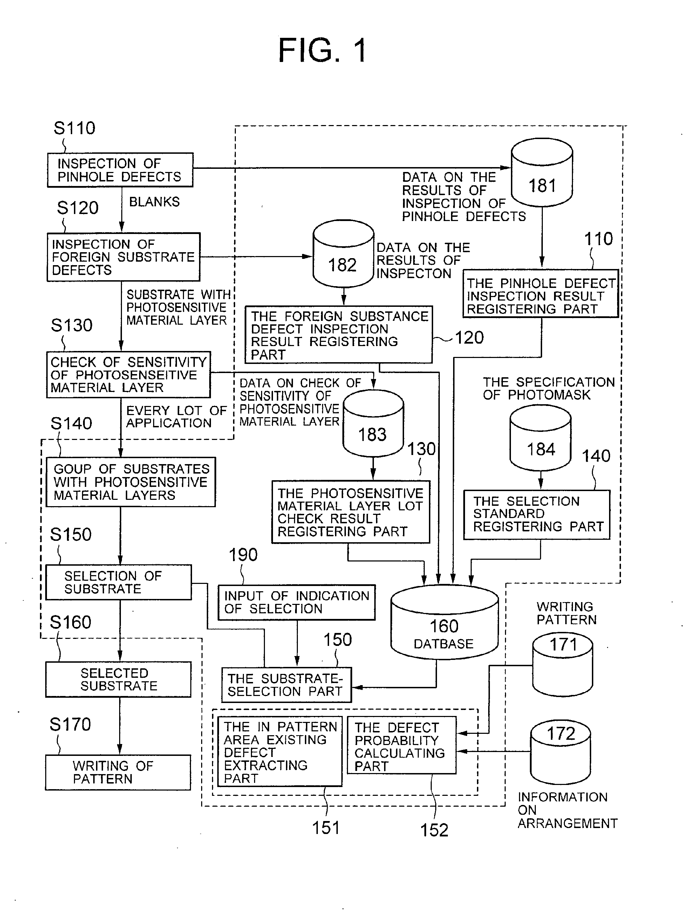

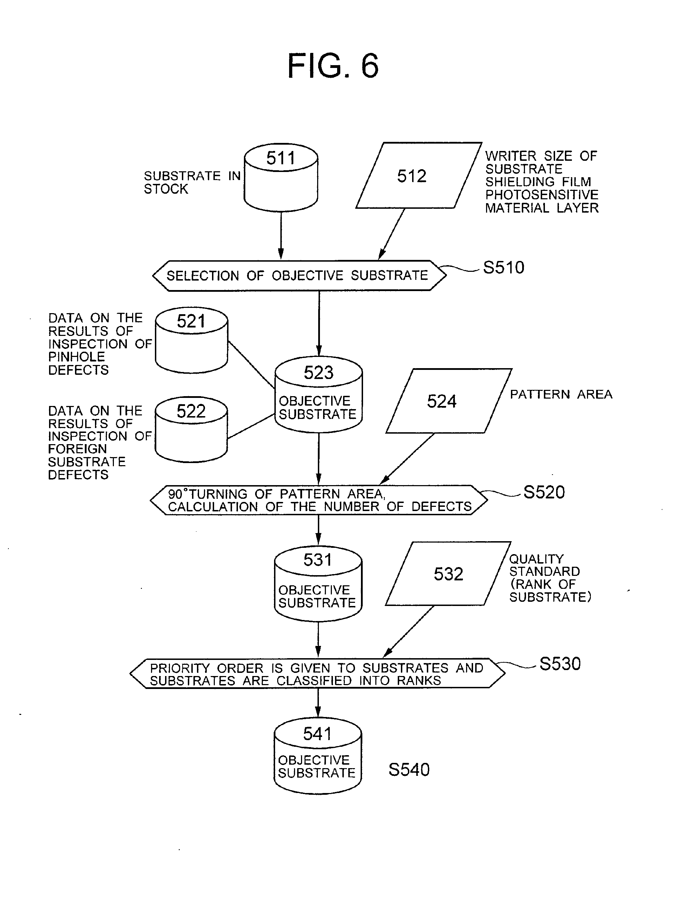

Referring to the drawing, an example of mode of operation of a substrate-selecting equipment of the present invention is explained. In Fig. 1, the substrate-selecting equipment and the step of selecting a substrate (S150) are shown inside the area bounded by the dotted line. Further, the steps S110 to S170 shown in Fig. 1 and the steps S510 to S540 shown in Fig. 6 are steps of processing.

In Figs. 1, 6 and 7, the numeral 110 designates the pinhole defect inspection result registering part for registering the results of the inspection for pinhole defects; numeral 120 designates the foreign substance defect inspection result registering part for registering the results of the inspection for foreign substance defects; numeral 130 designates the photosensitive material layer lot checking result registering part for registering the results of checking lots of photosensitive material layers; numeral 140 designates the selection standard registering part for registering the standard of selection of the substrate; numeral 150 designates the substrate-selecting part for selecting a substrate; numeral 151 designates the in- pattem-area-existing-defect-extracting-part for extracting defects which exist within a pattern area; numeral 152 designates the defect probability calculating part for calculating the probability that defects will exist; numeral 160 designates a database; numeral 171 designates a writing pattern; numeral 172 designates the information on an arrangement; numeral 181 designates data on the results of the inspection for pinhole defects; numeral 182 designates data on the results of the inspection for foreign substance defects: numeral 183 designates data on the results of a check on the sensitivity of lots of photosensitive material layers; numeral 184 designates the specification of a photomask; numeral 190 designates the selection indication input for indicating the selection of a substrate; numeral 511 designates the substrates in stock; numeral 512 designates the conditions of employment for the substrate; numeral 521 designates data on the results of the inspection for pinhole defects; numeral 522 designates data on the results of the inspection for the defects of a foreign substrate; numeral 523 designates objective substrates; numeral 524 designates a pattern area; numeral 531 designates an objective substrate; numeral 532 designates the quality standard (rank of a substrate); numeral 541 designates an objective substrate; numeral 601 designates an area of the substrate; numeral 605 designates a pattern area (writing area); numerals 611, 612, and 613 designate defects, respectively; numerals 621, 622 and 623 designate areas of defects, respectively; numerals 631, 632 and 633 designate pattern data, respectively; and numerals 651 and 652 each designate a pattern.

An example of a mode of operation of substrate-selecting equipment of the present invention is substrate-selecting equipment for selecting substrate qualitatively corresponding to an objective product from among a group of substrates provided with a photosensitive material layer used for producing a photomask, wherein the selected substrate is provided for the step of writing a pattern.

Then, as shown in Fig. 1, substrate-selecting equipment of the present example comprises the pinhole defect inspection results registering part 110 for registering the results of the inspection for pinhole defects (data 181 on the results of the inspection for pinhole defects) in database 160, the foreign substance defect inspection result registering part 120 for registering the results of the inspection for foreign substance defects existing in a substrate provided with photosensitive material layers (data 182 on the results of the inspection for foreign substance defects) in database 160, the photosensitive material layer lot checking result registering part 130 for registering the results of check of sensitivity of lots of photosensitive material layers every lot of photosensitive material layers(data 183 on the results of check of the inspection for sensitivity of photosensitive material layer every lot of photosensitive material layers) in database 160, the selection standard registering part 140 for registering the quality standard (the specification 184 of photomask) which is the standard of selection of substrate in database 160 and the substrate-selecting part 150 for selecting a substrate used for the production of objective products which are suitable qualitatively, on the basis of the results of the inspection for defects registered in database 160 (data 181 on the results of the inspection for pinhole defects and data 182 on the results of the inspection for foreign substance defects), the results of checking lots of photosensitive materials and the quality standard which is the standard of selection for the substrate.

First, referring to Fig. 1, the relation between the steps of processing a substrate carried out before writing is carried out on the substrate and individual parts of a substrate-selecting equipment of the present example is briefly explained.

First, an inspection for pinhole defects (S110) is carried out by means of the fixed pinhole inspection equipment for blanks in which a shielding layer or a shifter layer made of thin film of metal such as chromium is laminated on a transparent substrate made of, for example, quartz blanks. The results of the inspection are stored as data 181 in the results of the inspection for pinhole defects, sent through the pinhole defects inspection result registering part 110 to the database 160 and restored in the database 160.

Then, the blanks are cleaned and photosensitive material is applied to the blanks so that a photosensitive material layer is formed, wherein after forming the photosensitive material layer, the inspection (S120) for foreign substance defects is carried out by means of fixed inspection equipment. The results of the inspection are stored as data 182 in the results of the inspection for foreign substance defects. Further, the results of the inspection are sent through the foreign substance defect inspection result registering part 120 to the database 160, and stored in the database 160.

Further, a check (S130) of the sensitivity of the photosensitive material layer is carried out using test pieces (substrates for test) for every lot of photosensitive material layers, wherein the results of the inspection are stored as data 183 on a check of the sensitivity of lots of the sensitive material layer, sent through the photosensitive material layer sensitivity lot check result registering part 130 to the database 160, and stored in the database 160.

On the other hand, many substrates provided with a photosensitive material layer, which have been inspected for the sensitivity of the photosensitive material layer, are stored in a fixed storage (not shown).

Then, the selection (S150) of the substrate for selecting the objective substrate from among a group of substrates provided with a photosensitive material layer is carried out by means of the equipment of the present example, wherein selection (S160) of a substrate for writing is carried out and writing (S170) of a pattern on the substrate is carried out by means of a writer.

Then, the respective data 181, 182 on the inspection for defects and data 183 on the results of checking the sensitivity of lots of photosensitive material layers and the specification of the photomask are explained, and the selection of the substrate carried out in the substrate-selecting part 150 is explained.

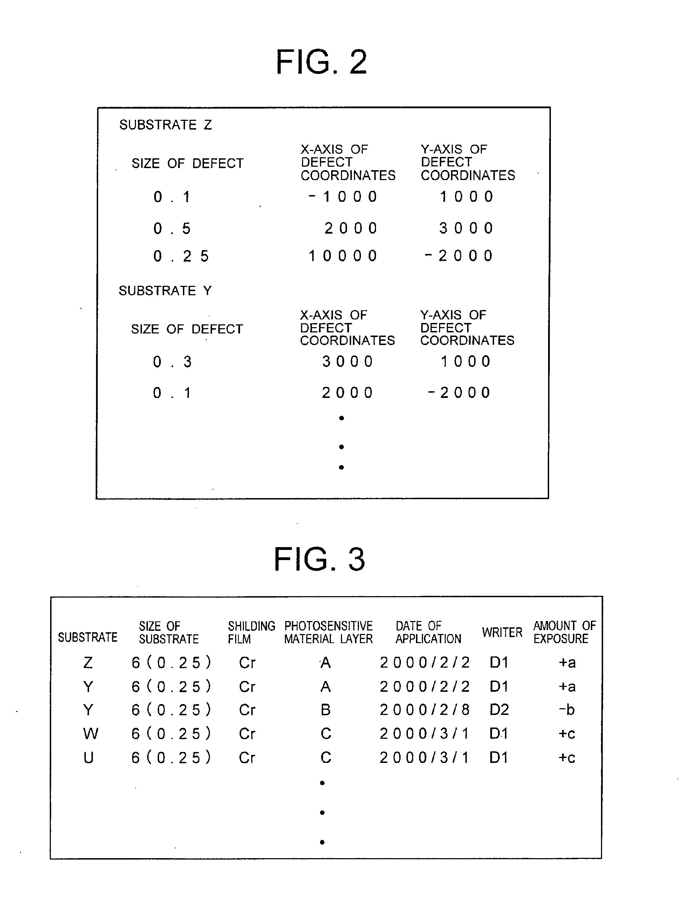

Data of the inspection for defects such as data 181 on the results of the inspection for pinhole defects or data 182 on the results of the inspection for foreign substance defects are captured about the size and position (the expression in coordinates of X-Y) of a defect of an individual substrate detected by the inspection for defects. They are shown, for example, as shown in Fig. 2.

In the data 183 on the results of checking the sensitivity of lots of photosensitive material layers, the sensitivity of individual application lots of photosensitive materials (wherein the lots differ according to the date of application) is detected for individual an test piece, and the exposure amount (irradiation amount) corresponding to a writer is determined. The size of the substrate, the kind of shielding film, the kind of photosensitive material layer, the date of application, the writer and exposure amount of the individual substrate correspond to each other, wherein the data 183 are expressed as shown in Fig. 3.

In Fig. 3, "+a" indicates an increase in the exposure amount by +a so that a correction of an uneven sensitivity between lots of photosensitive material layers is made.

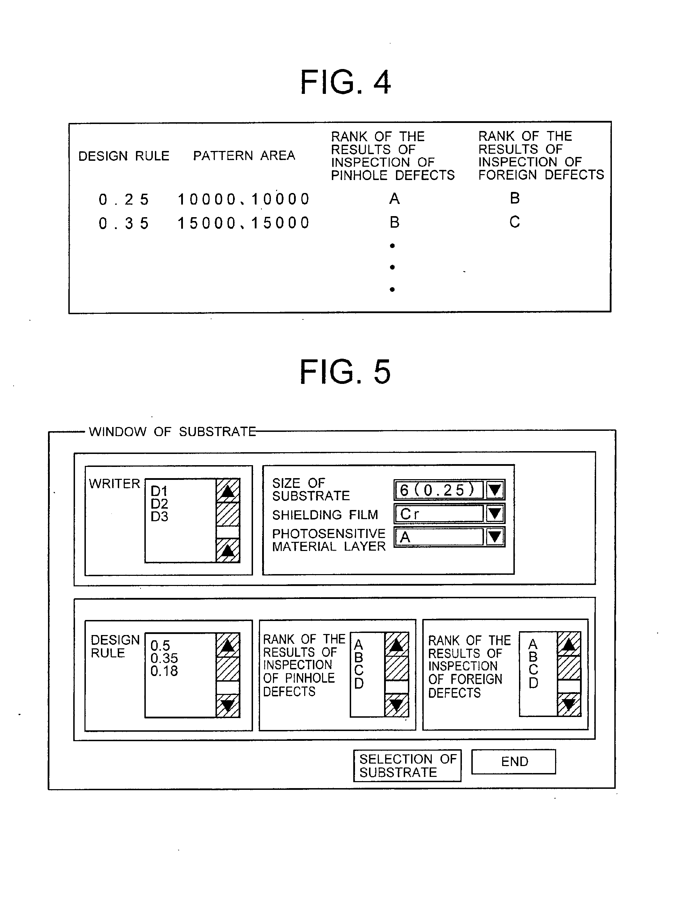

The quality standard being the standard of selection of the substrate (the specification of photomask 184), design rule, pattern area (the size of X direction and the size of Y direction thereof), rank of the results of the inspection for pinhole defects, rank of the results of the inspection for foreign substance defects and others correspond to each other, wherein the data 184 are expressed as shown in Fig. 4.

In this case, Fig. 4 shows an example of the quality standard of a substrate employed for writing by means of a raster type electron beam writer, wherein the description written in the first line in a table means that the pattern area is 10000 µm x 10000 µm, the rank of the results of the inspection for pinhole defects is "A" and the rank of the results of the inspection for foreign substance defects is "B" in case of a 0.25 µm address unit writing.

For example, in an input screen (of a terminal display of a computer) shown in Fig. 5, input (corresponding to "selection indication input 190") in case of selecting substrate corresponding to an objective product is carried out, selecting quality conditions such as substrate of a writer, the size of substrate and a kind of shielding film a kind of photosensitive material layer and quality conditions such as design rule, rank of the result of the inspection for pinhole defects, respectively.

Referring to Fig. 6, an example of flow (algorithm) of the first example wherein substrate qualitatively corresponding to an objective product is selected in the substrate-selecting part 150 is explained.

In the first example, a substrate is selected according to the information on the defects of the inspection for defects, the information on the results of checking lots of photosensitive material layers and the quality standard of the substrate being the standard of the selection of the substrate, wherein the number of defects existing inside a pattern area of individual photomask to be produced is extracted for individual objective substrate according to the information on the results of the inspection for defects registered in database in the in pattern area existing defect extracting part 151 of the substrate-selecting part 150. The rank is given to each objective substrate according to the number of defects extracted so that a desired substrate corresponding to the quality standard of the substrate is used.

First, the selection of an objective substrate from among substrates in stock is carried out, wherein objective substrates 523 corresponding to the conditions 512 of employment of the substrate such as a writer, the size of the substrate, the kind of shielding film and the kind of photosensitive material layer, designated by the selection indication input 190 are selected (S510).

Then, a substrate with a fixed pattern area (an objective substrate 531) is selected from among the objective substrates 523 referring to data 521 in the results of the inspection for pinhole defects and data 522 in the results of the inspection for foreign substance defects. The number of defects existing in the pattern area is obtained for a fixed pattern area and for a pattern area turned by 90° relative to the fixed pattern area, respectively (S520).

There is a case where the number of defects existing in a fixed pattern area changes by turning pattern area by 90°.

Substrates in the desired ranks of substrates are selected from among the objective substrates 531 according to the quality standard (rank of substrate) 532, and substrates are classified into ranks while stating the order of priority (S530) by which the objective substrates 541 with rank and the order of priority can be obtained (540).

In such a way, a rank is given to the objective substrate 541 of the objective product and further the order of priority is given thereto, wherein a desired substrate corresponding to the specification of the quality of the objective product is selected from among the objective substrates 541 so that the selected substrates are introduced to a writer.

A second example is explained in which substrates qualitatively corresponding to the objective products are selected in the substrate-selecting part 150.

In the second example, substrates are selected on the basis of the information in the results of the inspection for defects and the information in the results of checking lots of photosensitive material layers, wherein the probability P0 that no defect exists on the individual photomask is obtained on the basis of the information in the results of the inspection for defects registered in a database. Then, the objective substrates are classified into ranks according to the probability P0, by which substrates in a desired rank are selected to provide a substrate for the production of photomask.

In case of the probability P0 being obtained, the same calculation of probability is carried out for a fixed pattern area and for a pattern area turned by 90° relatively to the fixed pattern area of objective substrates so that the probability P0 is obtained for the respective relative angle. Then, the objective substrates are classified including the probability P0 in the respective relative angle by which a substrate with a desired rank is selected.

In this case, the objective substrates can be employed more effectively as compared with the first example.

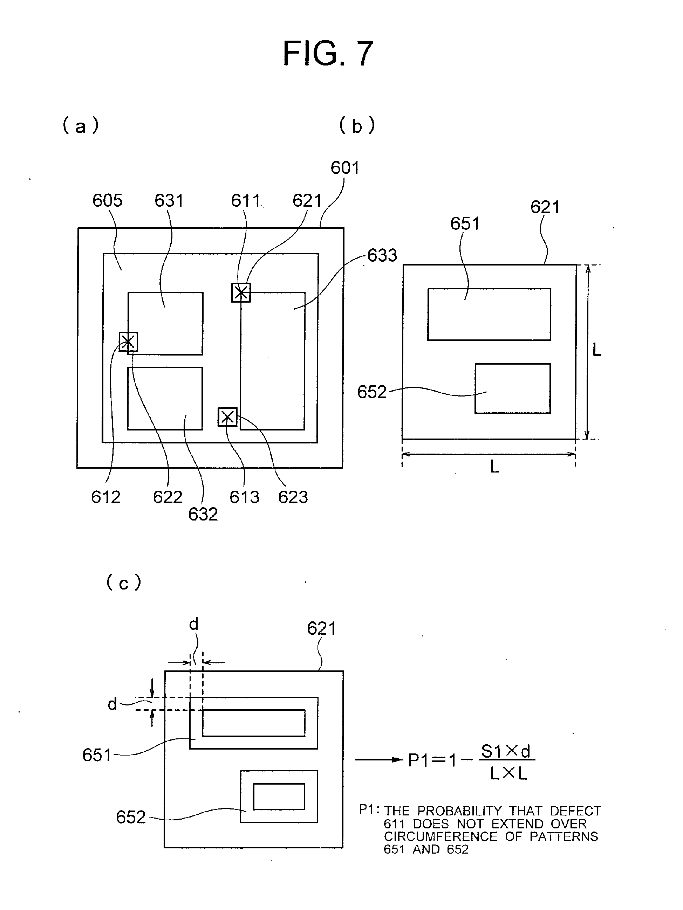

Then, referring to Fig. 7 the method of obtaining the probability P0 that no defect occurs on a photomask in a case, where there is a fixed relative relation of positions between the objective substrates and pattern areas, is explained.

In order to facilitate the explanation, a method of obtaining the probability P0 that no defect exists is explained, for a concrete example, on a photomask in which three defects (defects 611, 612, 613) and three pattern data areas 631, 632, 633 exist in a writing area 605 on a substrate area 601.

First, probabilities that defects cover the circumference of a pattern inside a pattern data area are calculated for individual defects 611, 612, 613. Probabilities P1, P2, P3 that no defect covers the circumference of pattern inside a pattern data area are calculated from the probabilities that defects cover the circumference of pattern inside a pattern data area, respectively. The probability P0 that no defect exists on a photomask is calculated from equation P0 = P1xP2xP3.

In this case, the relation of a position between objective substrates, pattern area, pattern data area, and patterns inside the pattern data area is determined according to a writing pattern 171 and the information on the arrangement 172.

As for the probability P1 that defect 611 does not cover the circumference of the pattern inside a pattern data area, the defect area 621 larger than the defect 611 considering errors and corresponding to the position of the defect 611 on the photomask produced is obtained and the non-occurrence probability that no defect exists on the circumference of the pattern inside the obtained defect area 621 is obtained.

The patterns existing inside the defect area 621 (the size of L x L) with the size larger than the defect 611 considering errors shown in Fig. 7(a) are patterns 651, 652 as shown as an enlarged view in Fig. 7(b), wherein the defect area 621 is a rectangular area with the length L of one side.

In this case, if a defect has a circle with a diameter d and the sum total of perimeters of patterns 651, 652 is S1, then the probability that the defect 611 covers a circumference of patterns in a pattern data area is approximated by (S1 x d)/(L x L).

Accordingly, the probability P1 that defect 611 does not cover the circumference of patterns in a pattern data area can be calculated by P1 = 1 - [(S1 x d)/(L x L)].

In the same way, the probabilities P2, P3 that defects 612, 613 cover the circumferences of the patterns in a pattern data area can be calculated, respectively.

The probability P0 that no defect exists on a photomask can be obtained from the obtained probabilities P1, P2 and P3.

In a case where there are three pattern areas, the probability P0 that no defect exists on a photomask can be also calculated basically in the same way.

### INDUSTRIAL APPLICABILITY

As mentioned above, the present invention makes it possible to provide a substrate-selecting equipment in which substrates for producing objective products can be selected, particularly from the aspect of quality of products, from among a group of substrates for forming photomasks with photosensitive material layers, employed for writing patterns.

Accordingly, the total productivity of the production process of photomasks can be improved compared to the conventional case. The present invention can cope with the higher precision and the higher quality of photomasks.

## Claims

1. A substrate-selecting equipment for selecting substrates, to be used for the production of photomasks having a pattern area, from among a group of substrates with a photosensitive material layer thereon, wherein the substrate-selecting equipment comprises:
- a pinhole defect-registering part (110) adapted to register in a database (160) the results of the inspection at pinhole defects of blanks, said blanks being said substrates without said photosensitive material layer thereon,
- a foreign substance defect-registering part (120) adapted to register in said database (160) the results of the inspection of foreign substances of said substrates with said photosensitive material layer thereon,
- a photosensitive material layer lot check result-registering part (130) adapted to register in said database (160) the results of a lot check of photosensitive material layers,
- a selection standard-registering part (140) adapted to register in said database (160) a quality standard which is the standard of selection of substrates, and
- a substrate-selection part (150) adapted to select substrates to be used for the production of photomasks from among said group of substrates with a photosensitive material layer thereon, on the basis of the results of the inspection of pinhole defects, the results of the inspection of foreign substances, the results of the lot check of photosensitive material layers, and the quality standard, all registered in said database (160),
**characterized in that**
the substrate-selecting equipment further comprises an in-pattern-area-existing-defect-extracting-part (151) adapted to extract defects existing in the area of said substrates corresponding to said pattern area, on the basis of the results of the inspection of pinhole defects, the results of the inspection of foreign substances and the results of the lot check of photosensitive material layers, all registered in said database (160).

2. A substrate-selecting equipment as claimed in claim 1, wherein the substrate-selecting equipment further comprises
a defect probability calculating part (152) for calculating the probability P0 that no defect exists and the probality that defects exist in the surrounding part of a pattern of the photomask to be produced or for calculating the probability P0 that no defect exists and the probability that defects exist inside a pattern of the photomask to be produced, on the basis of the information of the results of the inspection of defects of each substrate and the information of the results of checking a lot of photosensitive material layers registered in said database (160),
and wherein the substrate-selecting part (150) selects substrates to be used for the production of photomasks, on the basis of the above probabilities.

3. A substrate-selecting equipment as claimed in claim 2, wherein in the defect probability calculating part (152), defect areas (621, 622, 623) having a size larger than the size of defects decided considering errors, corresponding to the positions of the defects on the photomask to be produced, are obtained for all the defects (611, 612, 613) in a substrate, and
the probabilities (P1, P2, P3) that no defect exists in the surrounding part of patterns in the obtained defect areas (621) are obtained for all the defects in a substrate, wherein the product P1xP2xP3 of probabilities for all the defects (611, 612, 613) in a substrate are obtained, and
wherein the above-mentioned product P1xP2xP3 corresponds to the probability P0 that no defect exists in the surrounding part of the patterns of the photomask to be produced.

4. A substrate-selecting equipment as claimed in claim 2, wherein in the defect probability calculating part (152), defect areas (621, 622, 623) having a size larger than the size of defects decided considering errors, corresponding to the positions of the defects on the photomask to be produced, are obtained for all the defects in a substrate, and
the probabilities (P11, P12, P 13) that no defect exists inside patterns in the obtained defect area (621) are obtained for all the defects in a substrate,
wherein the product P11xP12xP13 of probabilities for all the defects in a substrate are obtained,
wherein the above-mentioned product (P11, P12, P13) corresponds to the probability P01 that no defect exists inside the patterns of the photomask to be produced.

## Patentansprüche

1. Substratauswahlgerät zum Auswählen von Substraten, die für die Herstellung von Photomasken mit einem Strukturbereich verwendet werden sollen, aus einer Gruppe von Substraten mit einer darauf befindlichen lichtempfindlichen Materialschicht, wobei das Substratauswahlgerät umfasst:
- einen Pinhole-Defekt-Registrierteil (110), der zum Registrieren der Ergebnisse der Inspektion von Pinhole-Defekten von Rohlingen in einer Datenbank (160) gestaltet ist, wobei die Rohlinge die Substrate ohne darauf befindlicher lichtempfindlicher Materialschicht sind,
- einen Fremdsubstanz-Defekt-Registrierteil (120), der zum Registrieren der Ergebnisse der Inspektion von Fremdsubstanzen der Substrate ohne darauf befindlicher lichtempfindlicher Materialschicht in der Datenbank (160) gestaltet ist,
- einen Lichtempfindliches-Material -Chargen-Prüfergebnis-Registrierteil (130), der zum Registrieren der Ergebnisse der Überprüfung der Charge von lichtempfindlichen Materialschichten in der Datenbank (160) gestaltet ist,
- Auswahlstandard-Registrierteil (140), der zum Registrieren eines Qualitätsstandards, der der Standard der Auswahl von Substraten ist, in der Datenbank (160) gestaltet ist, und
- einen Substratauswahlteil (150), der zum Auswählen von Substraten, die für die Herstellung von Photomasken verwendet werden sollen, aus der Gruppe von Substraten mit einer darauf befindlichen lichtempfindlichen Materialschicht auf der Basis der Ergebnisse der Inspektion von Pinhole-Defekten, der Ergebnisse der Inspektion von Fremdsubstanzen, der Ergebnisse der Überprüfung der Charge von lichtempfindlichen Materialschichten und des Qualitätsstandards, die alle in der Datenbank (160) registriert sind, gestaltet ist, **dadurch gekennzeichnet, dass**
das Substratauswahlgerät ferner einen In-Strukturbereich-existierender Defekt- Extraktionsteil (151) umfasst, der zum Extrahieren von in dem Bereich der Substrate, der dem Strukturbereich entspricht, existierenden Defekten auf der Basis der Ergebnisse der Inspektion von Pinhole-Defekten, der Ergebnisse der Inspektion von Fremdsubstanzen und der Ergebnisse der Überprüfung der Charge von lichtempfindlichen Materialschichten, die alle in der Datenbank (160) registriert sind, gestaltet ist.

2. Substratauswahlgerät nach Anspruch 1, wobei das Substratauswahlgerät ferner umfasst:
einen Defektwahrscheinlichkeitsberechnungsteil (152) zum Berechnen der Wahrscheinlichkeit P0, dass kein Defekt existiert, oder der Wahrscheinlichkeit, dass Defekte in dem umgebenden Teil einer Struktur der herzustellenden Photomaske existieren, oder zur Berechnung der Wahrscheinlichkeit P0, dass kein Defekt existiert, und der Wahrscheinlichkeit, dass Defekte innerhalb einer Struktur der herzustellenden Photomaske existieren, auf der Basis der Information der Ergebnisse der Inspektion von Defekten von jedem Substrat und der Information der Ergebnisse des Überprüfens einer Charge von lichtempfindlichen Materialschichten, die in der Datenbank (160) registriert sind,
und wobei der Substratauswahlteil (150) Substrate, die für die Herstellung von Photomasken verwendet werden sollen, auf der Basis der obengenannten Wahrscheinlichkeiten auswählt.

3. Substratauswahlgerät nach Anspruch 2, wobei in dem Defektwahrscheinlichkeitsberechnungsteil (152) Defektbereiche (621, 622, 623) mit einer Größe, die größer als die Größe von als Fehler eingeordneten Defekten ist, entsprechend den Positionen der Defekte auf der herzustellenden Photomaske, für all die Defekte (611, 612, 613) in einem Substrat erhalten werden, und
die Wahrscheinlichkeiten (P1, P2, P3), dass kein Defekt in dem umgebenden Teil von Strukturen in den erhaltenen Defektbereichen (621) existieren, für all die Defekte in einem Substrat erhalten werden, wobei das Produkt P1 x P2 x P3 von Wahrscheinlichkeiten für all die Defekte (611, 612, 613) in einem Substrat erhalten wird, und
wobei das oben erwähnte Produkt P1 x P2 P3 der Wahrscheinlichkeit P0 entspricht, dass kein Defekt in dem umgebenden Teil der Strukturen der herzustellenden Photomaske existiert.

4. Substratauswahlgerät nach Anspruch 2, wobei in dem Defektwahrscheinlichkeitsberechnungsteil (152) Defektbereiche (621, 622, 623) mit einer Größe, die größer als die Größe von als Fehler eingeordneten Defekten ist, entsprechend den Positionen der Defekte auf der herzustellenden Photomaske, für all die Defekte in einem Substrat erhalten werden, und
die Wahrscheinlichkeiten (P11, P12, P13), dass in den Strukturen in dem erhaltenen Defektbereich (621) kein Defekt existiert, für all die Defekte in einem Substrat erhalten werden,
wobei das Produkt P11 x P12 P13 von Wahrscheinlichkeiten für all die Defekte in einem Substrat erhalten wird,
wobei das oben erwähnte Produkt (P11, P12, P13) der Wahrscheinlichkeit P01 entspricht, dass kein Defekt in den Strukturen der herzustellenden Photomaske existiert.

## Revendications

1. Équipement de sélection de substrats servant à sélectionner des substrats à employer pour la production de photomasques ayant une zone de motif parmi un groupe de substrats avec une couche de matière photosensible qui les recouvre, dans lequel l'équipement de sélection de substrats comprend :
- une partie d'enregistrement de défaut de piqûre (110) conçue pour enregistrer dans une base de données (160) les résultats de l'inspection au niveau des défauts de piqûre d'ébauches, lesdites ébauches étant lesdits substrats sans ladite couche de matière photosensible qui les recouvre,
- une partie d'enregistrement de défauts de substance étrangère (120) conçue pour enregistrer dans ladite base de données (160) les résultats de l'inspection de substances étrangères des dits substrats avec ladite couche de matière photosensible qui les recouvre,
- une partie d'enregistrement de résultats de contrôle de lot de couche de matière photosensible (130) conçue pour enregistrer dans ladite base de données (160) les résultats d'un contrôle de lot de couches de matière photosensible,
- une partie d'enregistrement de norme de sélection (140) conçue pour enregistrer dans ladite base de données (160) une norme de qualité qui constitue la norme de sélection de substrats, et
- une partie de sélection de substrats (150) conçue pour sélectionner des substrats à utiliser dans la production de photomasques parmi ledit groupe de substrats avec une couche de matière photosensible qui les recouvre, sur la base des résultats de l'inspection de défauts de piqûre, des résultats de l'inspection de substances étrangères, des résultats du contrôle de lot de couches de matière photosensible et de la norme de qualité, tous étant enregistrés dans ladite base de données (160),
**caractérisé en ce que**
l'équipement de sélection de substrats comprend en outre une partie d'extraction de défauts de zone dans le motif (151) conçue pour extraire des défauts existant dans la zone des dits substrats correspondant à ladite zone de motif, sur la base des résultats de l'inspection de défauts de piqûre, des résultats de l'inspection de substances étrangères et des résultats du contrôle de lot de couches de matière photosensible, tous étant enregistrés dans ladite base de données (160).

2. Équipement de sélection de substrats selon la revendication 1, dans lequel l'équipement de sélection de substrats comprend en outre
une partie de calcul de probabilité de défaut (152) servant à calculer la probabilité P0 qu'aucun défaut n'existe et la probabilité que des défauts existent dans la partie environnante d'un motif du photomasque à produire ou à calculer la probabilité P0 qu'aucun défaut n'existe et la probabilité que des défauts existent à l'intérieur d'un motif du photomasque à produire, sur la base des informations des résultats de l'inspection de défauts de chaque substrat et des informations des résultats du contrôle d'un lot de couches de matière photosensible enregistrés dans ladite base de données (160),
et dans lequel la partie de sélection de substrat (150) sélectionne les substrats à utiliser pour la production de photomasques sur la base des probabilités ci-dessus.

3. Équipement de sélection de substrats selon la revendication 2, dans lequel, dans la partie de calcul de probabilité de défaut (152), des zones de défaut (621, 622, 623) ayant une taille supérieure à la taille des défauts considérés après décision comme des erreurs, correspondant aux positions des défauts sur le photomasque à produire, sont obtenues pour tous les défauts (611,612,613) dans un substrat, et
les probabilités (P 1, P2, P3) qu'aucun défaut n'existe dans la partie environnante des motifs dans les zones de défaut obtenues (621) sont obtenues pour tous les défauts dans un substrat, dans lequel le produit P1xP2xP3 des probabilités pour tous les défauts (611, 612, 613) dans un substrat sont obtenues, et
dans lequel le produit susmentionné P1xP2xP3 correspond à la probabilité P0 qu'aucun défaut n'existe dans la partie environnante des motifs du photomasque à produire.

4. Équipement de sélection de substrats selon la revendication 2, dans lequel, dans la partie de calcul de probabilité de défauts (152), des zones de défaut (621, 622, 623) ayant une taille supérieure à la taille des défauts considérés après décision comme des erreurs, correspondant aux positions des défauts sur le photomasque à produire, sont obtenues pour tous les défauts dans un substrat, et
les probabilités (P11, P12, P13) qu'aucun défaut n'existe dans les motifs dans la zone de défaut obtenue (621) sont obtenues pour tous les défauts dans un substrat,
dans lequel le produit P11xP12xP13 des probabilités pour tous les défauts dans un substrat sont obtenues,
dans lequel le produit susmentionné (P11xP12xP13) correspond à la probabilité P01 qu'aucun défaut n'existe à l'intérieur du photomasque à produire.
